# EUROPEAN PATENT SPECIFICATION

(11) **EP 4 120 050 B1**
(45) Date of publication and mention of the grant of the patent: **14.10.2026**
(21) Application number: 22176833.6
(22) Date of filing: 30.03.2018
(51) Int. Cl.: G06F 1/18, G06F 1/20, H05K 7/20

(54) **CHASSIS OF SERVER AND SERVER**
SERVERCHASSIS UND SERVER
CHÂSSIS DE SERVEUR ET SERVEUR

(43) Date of publication of application: 18.01.2023
(62) Document number(s) of the earlier application(s) in accordance with Art. 76 EPC: 18912791.3 / 3 716 009
(73) Proprietor: Huawei Technologies Co., Ltd., Shenzhen, Guangdong 518129 (CN)
(72) Inventor: SUN, Hao, Shenzhen, 518129 (CN); CHEN, Lv, Shenzhen, 518129 (CN); LU, Dongming, Shenzhen, 518129 (CN)
(74) Representative: Gill Jennings & Every LLP

(56) References cited:
- US-A1- 2014 071 618
- US-A1- 2014 092 541

## Description

### TECHNICAL FIELD

This application relates to the server field, and in particular, to a chassis of a server and a server.

### BACKGROUND

A server, also referred to as a server, is a device for providing a computing service. To provide a highly reliable service, there are relatively high requirements on a processing capability, stability, reliability, security, scalability, manageability, and the like of the server.

To meet the requirements, a module (for example, a processor) in the server need to maintain stable operating performance. To achieve stable operating performance of the module, a chassis of the server needs to meet heat dissipation requirements of modules.

Currently, more modules are configured in the server. When an architecture of the chassis of the server is designed, a power supply air cavity is disposed in a system air cavity, so that the power supply air cavity shares heat dissipation space with the system air cavity of another component. However, in this design, the power supply air cavity is coupled to the system air cavity. Heat of a high-power supply module (for example, the processor) needs to be dissipated first by using airflow, and then heat of another module (for example, a power supply) is dissipated by using the airflow. This affects a heat dissipation capability and a power supply evolution capability of the power supply, and affects heat dissipation performance of the entire server.

Therefore, how to improve heat dissipation performance of the chassis of the server becomes a problem to be urgently resolved.

US 2014/0092541 A1 discloses a server including a fan module and a rear board disposed side by side at the back of a backplane in a hot plug manner, so that the fan module or the rear board needs only to be drawn out of the back of the server during maintenance of the fan module or the rear board, thereby implementing online replacement of the fan module or the rear board.

### SUMMARY

This application provides a chassis of a server and a server. A heat dissipation structure of the chassis of the server can improve heat dissipation performance of the server. The invention is defined by the appended claims. Embodiments not falling within the scope of the claims are for illustration.

According to a first aspect, a chassis of a server is provided. The chassis of the server includes a backplane. The backplane is disposed in the chassis of the server, and the backplane includes a first subboard, a second subboard, and at least one air baffle. The first subboard is isolated from the second subboard, the first subboard is parallel to the second subboard, and both the first subboard and the second subboard are perpendicular to a side wall of the chassis of the server. The at least one air baffle is located between the first subboard and the second subboard, and each of the at least one air baffle forms an included angle with the first subboard and forms an included angle with the second subboard. Space enclosed by the first subboard, the second subboard, and the side wall, an upper wall, and a lower wall of the chassis is divided into a first air cavity and at least one second air cavity by using the at least one air baffle. A hole used for air circulation is disposed in an area enclosing the first air cavity, and the first air cavity is used for at least one first module to dissipate heat. Each of the at least one first module is connected to the first subboard by using an interface that is of the first subboard and that is in an air intake vent area of the first air cavity. A hole used for air circulation is disposed in an area enclosing each second air cavity, and the second air cavity is used for at least one second module to dissipate heat. Each of the at least one second module is connected to the second subboard by using an interface that is of the second subboard and that is in an air exhaust vent area of the second air cavity.

Compared with a heat dissipation structure of a chassis of a conventional server, in this application, the backplane is disposed as a structure of two isolated subboards, so that a cavity is formed between the two subboards. The at least one air baffle is disposed between the two subboards, to divide the cavity into the first air cavity that is used for the first module to dissipate heat and the second air cavity that is specially used for the second module to dissipate heat. In other words, in this application, the first module and the second module each have an independent heat dissipation air cavity. Therefore, in this application, independent heat dissipation of the first module and the second module is implemented. This improves heat dissipation efficiency of the first module and that of the second module, and further improves heat dissipation performance of the entire server.

In a possible implementation, the first air cavity is enclosed by a first part of the first subboard, a first part of the second subboard, a first part of the upper wall of the chassis, a first part of the lower wall, and the air baffle. That the hole used for air circulation is disposed in the area enclosing the first air cavity includes: A first hole is disposed in the first part of the first subboard, a second hole is disposed in the first part of the second subboard, and in the first air cavity, airflow enters the first air cavity from the first hole in the first subboard, and flows out of the first air cavity through the second hole in the second subboard.

In this application, the first hole is disposed on the first subboard, and the second hole is disposed on the second subboard. The airflow that takes heat of the first module away can enter the first air cavity from the first hole, and flow out of the first air cavity through the second hole. Finally, the airflow flows out of the chassis through an air exhaust vent of the chassis of the server. Therefore, the first air cavity in this application can be used for the first module to dissipate heat.

In another possible implementation, when the first air baffle intersects with the side wall of the chassis of the server, the second air cavity is enclosed by a second part of the second subboard, a second part of the side wall of the chassis of the server, a second part of the upper wall, a second part of the lower wall, and the first air baffle. The first air baffle is any one of the at least one air baffle.

In another possible implementation, when the first air baffle does not intersect with the side wall of the chassis of the server, the second air cavity is enclosed by a second part of the first subboard, a second part of the second subboard, a second part of the side wall of the chassis of the server, a second part of the upper wall, a second part of the lower wall, and the first air baffle.

In another possible implementation, that the hole used for air circulation is disposed in the area enclosing the second air cavity includes:
A third hole is disposed in the second part of the second subboard, a fourth hole is disposed in the second part of the side wall of the chassis, and in the second air cavity, airflow enters the second air cavity from the fourth hole in the side wall of the chassis, and flows out of the second air cavity through the third hole in the second subboard.

In this application, the fourth hole is disposed on the side wall of the chassis, and the third hole is disposed on the second subboard. The airflow can enter the second air cavity from the fourth hole, and flow out of the second air cavity through the third hole. Finally, the airflow passes through the at least one second module to take heat of the second module away, and flows out of the chassis. Therefore, the second air cavity in this application can be used for the second module to dissipate heat.

In another possible implementation, that the hole used for air circulation is disposed in the area enclosing the second air cavity includes:
A third hole is disposed in the second part of the second subboard, a fourth hole is disposed in the second part of the side wall of the chassis, a fifth hole is disposed in the second part of the upper wall of the chassis, and in the second air cavity, airflow enters the second air cavity from the fourth hole and/or the fifth hole, and flows out of the second air cavity through the third hole in the second subboard.

In this application, the fourth hole is disposed on the side wall of the chassis, the fifth hole is disposed in the second part of the upper wall of the chassis, and the third hole is disposed on the second subboard. The airflow can enter the second air cavity from the fourth hole and/or the fifth hole, and flow out of the second air cavity through the third hole. Finally, the airflow passes through the at least one second module to take the heat of the second module away, and flows out of the chassis. Therefore, the second air cavity in this application can be used for the second module to dissipate heat.

In another possible implementation, a value of a spacing between the first subboard and the second subboard belongs to a preset set, and the value of the spacing between the first subboard and the second subboard is related to a size of the chassis of the server and/or a module layout inside the chassis.

For example, a minimum distance between the first subboard and the second subboard is 20 mm or 25 mm, and a maximum distance between the first subboard and the second subboard is 50 mm or 60 mm. This application is not limited thereto.

It should be understood that a distance between the two subboards determines sizes of the two air cavities. The size of the air cavity can affect resistance and an air speed of the air cavity, and further affect heat dissipation performance. During actual application, the spacing between two subboards is determined based on factors such as an actual depth of a chassis, an architecture of the chassis, and a size of the chassis. This application is not limited thereto.

In another possible implementation, the first subboard is connected to the second subboard by using a busbar component, and the busbar component is configured to supply power to the second subboard.

In another possible implementation, a fastening support bracket is disposed between the first subboard and the second subboard, and the fastening support bracket is configured to fasten the first subboard and the second subboard, to form the spacing between the first subboard and the second subboard.

In another possible implementation, a hole opening rate of the first subboard is greater than a first hole opening rate threshold, and a hole opening rate of the second subboard is greater than a second hole opening rate threshold. The hole opening rate of the first subboard is used to indicate a ratio of a sum of areas of all holes on the first subboard to an area of the first subboard, and the hole opening rate of the second subboard is used to indicate a ratio of a sum of areas of all holes on the second subboard to an area of the second subboard.

In another possible implementation, when the areas of all the holes are the same, the hole opening rate of the first subboard may also indicate a quantity of holes per unit area of the first subboard. Similarly, the hole opening rate of the second subboard may also indicate a quantity of holes per unit area of the second subboard.

It should be understood that the first hole opening rate threshold or the second hole opening rate threshold may be a maximum hole opening rate of an existing single-layer backplane or a closely-bonded two layers of backplanes. For example, based on a service requirement, the first hole opening rate threshold and the second hole opening rate threshold are 20%.

In a single-layer backplane structure of the conventional server, a signal and a power supply need to be routed on the backplane at the same time. Therefore, there is limitation on opening a hole, and a hole opening rate is relatively small, for example, is only 10%. However, in this application, in a two-layer structure design, the signal and the power supply are separately routed on different subboards, and less routing is required on a single subboard. Therefore, in this application, there is less limitation on opening a hole, and the hole opening rate is increased. Because the hole opening rate of the subboard in this application is relatively large, resistance of the air cavity to the airflow can be reduced. This ensures smooth airflow in the chassis and improves heat dissipation performance of the server.

It should be understood that, during actual application, a specific value of the first hole opening rate threshold and that of the second hole opening rate threshold may be determined based on an actual situation. This application is not limited thereto.

In another possible implementation, each of the at least one first module may include a central processing unit (central processing unit, CPU) module or a graphics processing unit (graphics processing unit, GPU) module. Each of the at least one second module is provided with an independent fan.

It should be understood that the second module may further include another module. For example, the second module may further include a switching module. This application is not limited thereto.

For example, the second module may include a power supply module, an input/output (input/output, IO) module, a source-measure unit (source measure unit, SMU) module, a serial digital interface (serial digital interface, SDI) module, a field programmable gate array (field programmable gate array, FPGA) heterogeneous computation module, or the like. This application is not limited thereto, provided that heat of the second module is dissipated independently and provided that the second module has an independent fan that actively dissipates heat.

It should be understood that in this application, the CPU module and the GPU module may be collectively referred to as a computation module.

In this application, the power supply module can be decoupled from the computation module, to implement independent heat dissipation of the power supply module and the computation module. Therefore, in this application, heat accumulation between the power supply module and the computation module can be avoided, and heat dissipation performance of the server can be improved.

In another possible implementation, the chassis is divided, by using the backplane, into first space in contact with the first subboard and second space in contact with the second subboard. The first module is located in the first space in the chassis, and the second module is located in the second space in the chassis.

Specifically, in the conventional server, the second module and the first module (for example, the power supply module and the computation module) are usually deployed in a same area in the chassis. As a result, the power supply module occupies heat dissipation space of the computation module, and there is heat accumulation. This affects heat dissipation of the power supply module. However, in this application, the first module and the second module are separated and independent of each other, and heat dissipation space of the first module is not coupled to that of the second module. This can implement independent heat dissipation of the two modules.

In another possible implementation, the first subboard is a power supply backplane, and the second subboard is a signal backplane.

It should be understood that in this application, the power supply backplane may be configured to be connected to the power supply module, and convert a voltage to supply power to modules. The signal backplane may be used for communication between the modules in a system.

Therefore, in this application, the backplane in the server is disposed as a double-layer structure in which the power supply backplane and the signal backplane are combined. There is a specific spacing between the signal backplane and the power supply backplane, and the cavity is divided, by using the air baffle, into the first air cavity that is used for the first module to dissipate heat and the second air cavity that is used for the second module to dissipate heat. In this application, the first module and the second module each have an independent heat dissipation air cavity. Therefore, in this application, independent heat dissipation of the first module connected to the power supply backplane and the second module connected to the signal backplane is implemented. This reduces load of a heat dissipation structure of the system in this application, and improves heat dissipation performance of the entire server.

In another possible implementation, the server is a rack server or a blade server.

According to a second aspect, a server is provided. The server includes a chassis, at least one first module, and at least one second module. The chassis includes a backplane. The backplane is disposed in the chassis, and the backplane includes a first subboard, a second subboard, and at least one air baffle. The first subboard is isolated from the second subboard, the first subboard is parallel to the second subboard, and both the first subboard and the second subboard are perpendicular to a side wall of the chassis of the server. The at least one air baffle is located between the first subboard and the second subboard, and each of the at least one air baffle forms an included angle with the first subboard and forms an included angle with the second subboard. Space enclosed by the first subboard, the second subboard, and the side wall, an upper wall, and a lower wall of the chassis is divided into a first air cavity and at least one second air cavity by using the at least one air baffle. A hole used for air circulation is disposed in an area enclosing the first air cavity, and the first air cavity is used for the at least one first module to dissipate heat. Each of the at least one first module is connected to the first subboard by using an interface that is of the first subboard and that is in an air intake vent area of the first air cavity. A hole used for air circulation is disposed in an area enclosing each second air cavity, and the second air cavity is used for the at least one second module to dissipate heat. Each of the at least one second module is connected to the second subboard by using an interface that is of the second subboard and that is in an air exhaust vent area of the second air cavity.

Compared with a heat dissipation structure of a chassis of a conventional server, in this application, the backplane is disposed as a structure of two isolated subboards, so that a cavity is formed between the two subboards. The at least one air baffle is disposed between the two subboards, to divide the cavity into the first air cavity that is used for the first module to dissipate heat and the second air cavity that is specially used for the second module to dissipate heat. In other words, in this application, the first module and the second module each have an independent heat dissipation air cavity. Therefore, in this application, independent heat dissipation of the first module and the second module is implemented. This improves heat dissipation efficiency of the first module and that of the second module, and further improves heat dissipation performance of the entire server.

For a structure of the chassis of the server in the second aspect, refer to the structure of the chassis of the server in the first aspect. Details are not described herein again.

In this application, the implementations provided in the foregoing aspects may be further combined to provide more implementations.

### BRIEF DESCRIPTION OF DRAWINGS

FIG. 1 is a schematic structural diagram of a conventional server;
FIG. 2 is a schematic structural diagram of a server according to this application;
FIG. 3 is a schematic diagram of a backplane structure according to this application;
FIG. 4 is an exploded diagram of a backplane structure according to this application;
FIG. 5 is a top view of a backplane structure according to this application;
FIG. 6 is an another schematic structural diagram of a server according to this application;
FIG. 7 is an another schematic structural diagram of a server according to this application; and
FIG. 8 is a schematic structural diagram of a blade server according to this application.

### DESCRIPTION OF EMBODIMENTS

The following describes the technical solutions of this application with reference to the accompanying drawings.

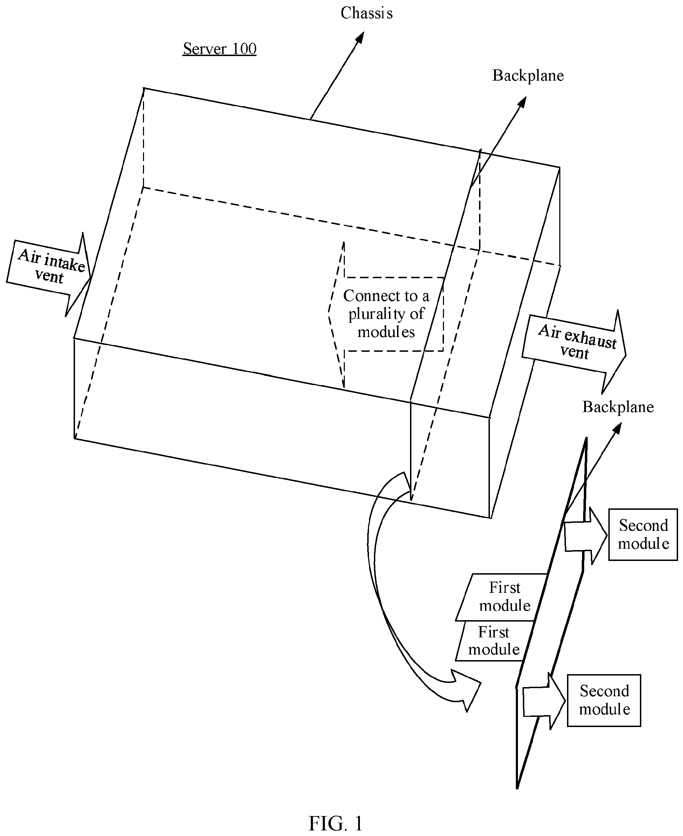

FIG. 1 is a schematic structural diagram of a conventional server. A backplane and a plurality of modules connected to the backplane are disposed in a chassis of a server 100 shown in FIG. 1.

In FIG. 1, the backplane and the module may be connected by using a connector. For example, the connector may be a high-density connector. Interfaces for interconnection may be disposed on the backplane and each of the plurality of modules. The plurality of modules may be directly connected to the backplane, or may be connected to the backplane by using a cable. In addition, the backplane in FIG. 1 may be a single-layer backplane, or may be a closely-bonded two layers of backplanes.

The plurality of modules may include at least one first module and at least one second module. The first module may also be referred to as a computation module or a computing node. The first module may include a central processing unit (central processing unit, CPU) module or a graphics processing unit (graphics processing unit, GPU) module. The second module is a module having an independent fan, and includes any one of a power supply module, an input/output (input/output, IO) module, a source-measure unit (source measure unit, SMU) module, a serial digital interface (serial digital interface, SDI) module, and a field programmable gate array (field programmable gate array, FPGA) heterogeneous computation module. A specific form of the second module in this embodiment of this application is not limited to the content described above.

As shown in FIG. 1, the first module may be disposed on one side of the backplane, and the second module may be disposed on the other side of the backplane.

As shown in FIG. 1, the first module (for example, the CPU or the GPU) and the second module (for example, the power supply module) in the chassis of the conventional server are disposed in a same heat dissipation air cavity (which may also be referred to as a system air cavity). In other words, the plurality of modules share one heat dissipation air cavity. In the chassis with the foregoing arrangement, an air cavity of the first module is usually coupled with an air cavity of the second module. Therefore, a direction of heat dissipation airflow in the server shown in FIG. 1 is as follows: The heat dissipation airflow may enter the chassis from one end of the chassis of the server (which may also be referred to as a front end of the server), and pass through the modules. For example, the heat dissipation airflow first passes through the first module, then passes through the second module, and flows out of the chassis from the other end of the chassis (which may also be referred to as a rear end of the server).

It should be understood that in this embodiment of this application, the term "air cavity" may indicate a carrier for airflow circulation.

It can be learned from FIG. 1 that heat dissipation of the plurality of modules in a heat dissipation structure of the chassis of the server results in heat accumulation. Specifically, after the heat dissipation airflow enters the chassis of the server from an air intake vent of the server, heat of each module is taken away each time the airflow passes through the module, and a temperature of the airflow increases as a quantity of modules through which the airflow passes increases. In addition, as a computing capability of the server is enhanced, power consumption density is gradually increased, and power consumption of a high-power module (such as the CPU and the GPU) is increasingly high. Therefore, for a module close to the rear end (an air exhaust vent) of the server, for example, the second module (for example, the power supply module), after the airflow first passes through the first module (for example, the CPU), heat of the first module is taken away, and the temperature of the airflow in the chassis of the server increases. In this case, a cooling effect of the airflow becomes poor. This does not facilitate heat dissipation of a module at the rear end, and affects heat dissipation performance of the entire server.

It should be noted that although the modules such as the power supply module have independent fans, there is only one air intake vent of the server, and the fans can only control an airflow direction, and cannot control a sequence of the modules through which the airflow passes in a same air cavity.

In view of the mentioned problems, an embodiment of this application provides a chassis of a server. In the chassis of the server, an air cavity of a first module is decoupled from an air cavity of a second module, and the first module and the second module each may dissipate heat by using an independent air cavity. Therefore, according to the technical solutions provided in the embodiments of this application, heat accumulation between the first module and the second module can be avoided, and heat dissipation efficiency of the first module and that of the second module, and heat dissipation performance of the entire server are improved.

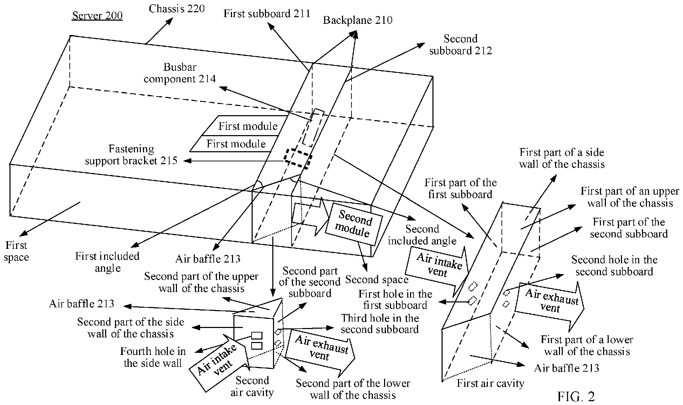

For ease of understanding and description, as an example instead of a limitation, the following describes in detail an architecture of a server in the embodiments of this application with reference to the accompanying drawings. FIG. 2 is a schematic structural diagram of a chassis of a server according to this application. As shown in FIG. 2, a chassis 220 of a server 200 includes a backplane 210, and the backplane 210 further includes a first subboard 211, a second subboard 212, and an air baffle 213. The first subboard 211 is isolated from the second subboard 212, the first subboard 211 is parallel to the second subboard 212, and both the first subboard 211 and the second subboard 212 are perpendicular to a side wall of the chassis of the server. The air baffle 213 is located between the first subboard 211 and the second subboard 212, and the air baffle 213 forms an included angle with the first subboard 211 and forms an included angle with the second subboard 212.

At least one air baffle 213 (one air baffle 213 is used as an example in FIG. 2) divides space enclosed by the first subboard 211, the second subboard 212, and the side wall, an upper wall, and a lower wall of the chassis 220 into a first air cavity and at least one second air cavity (FIG. 2 shows an example of only one second air cavity). A hole used for air circulation is disposed in an area enclosing the first air cavity, and the first air cavity is used for at least one first module to dissipate heat. Each first module is connected to the first subboard by using an interface that is of the first subboard and that is in an air intake vent area of the first air cavity. A hole used for air circulation is disposed in an area enclosing each of the second air cavity, and the second air cavity is used for at least one second module to dissipate heat. Each second module is connected to the second subboard by using an interface that is of the second subboard and that is in an air exhaust vent area of the second air cavity.

Two included angles are respectively formed between the air baffle 213 and the first subboard 211 and between the air baffle 213 and the second subboard 212. A first included angle is formed between the air baffle 213 and the first subboard 211, and a second included angle is formed between the air baffle 213 and the second subboard 212.

In a possible embodiment, the air baffle 213 intersects with the first subboard 211 to form an included angle and intersects with the second subboard 212 to form an included angle. The air baffle 213 may intersect with the first subboard and the second subboard in a plurality of forms. When the air baffle forms an included angle with the first subboard and forms an included angle with the second subboard, but when the air baffle intersects with the side wall, the side wall, the upper wall, and the lower wall of the chassis, the first subboard, and the second subboard may form different second air cavities in various combinations. For example, as shown in FIG. 2, the air baffle 213 separately intersects with the first subboard 211, the side wall of the chassis, and the second subboard 212 on a straight line. When the air baffle forms an included angle with the first subboard and forms an included angle with the second subboard, but when the air baffle does not intersect with the side wall, the side wall, the upper wall, and the lower wall of the chassis, the first subboard, and the second subboard may form different second air cavities in various combinations, and a hole may be opened in a different manner.

Optionally, the first subboard 211 is connected to the second subboard 212 by using a busbar (Busbar) component 214, and the busbar component 214 is configured to supply power to the second subboard 212. A signal may be transferred between the first subboard 211 and the second subboard 212 by using the busbar component 214.

Optionally, a fastening support bracket 215 is disposed between the first subboard 211 and the second subboard 212, and the fastening support bracket 215 is configured to support the first subboard 211 and the second subboard 212, to form a spacing between the first subboard 211 and the second subboard 212.

Optionally, a value of the spacing between the first subboard 211 and the second subboard 212 belongs to a preset set, and the value of the spacing between the first subboard and the second subboard is related to a size of the chassis of the server and/or a module layout inside the chassis. For example, a minimum value of the preset set may be 20 mm, 25 mm, or the like, and a maximum value of the preset set may be 50 mm or 60 mm. This embodiment of this application is not limited thereto.

It should be understood that a distance between the two subboards affects sizes of the two air cavities. The size of the air cavity can affect resistance and an air speed of the air cavity, and further affect heat dissipation performance. During actual application, a spacing between two subboards is determined based on factors such as an actual size parameter of a chassis (for example, a depth of the chassis, namely, a distance from a front end of the chassis to a rear end of the chassis) and/or a module layout inside the chassis. This embodiment of this application is not limited thereto.

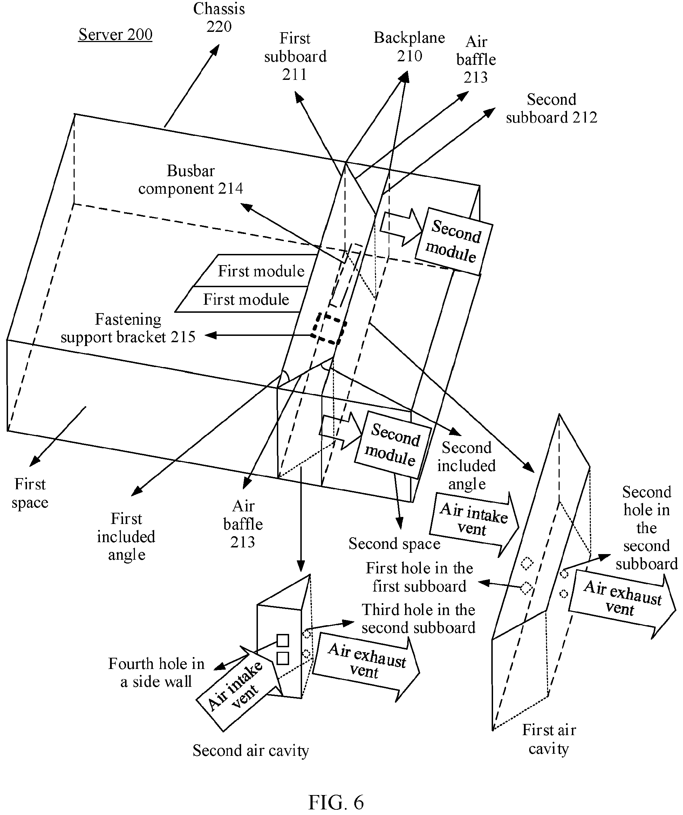

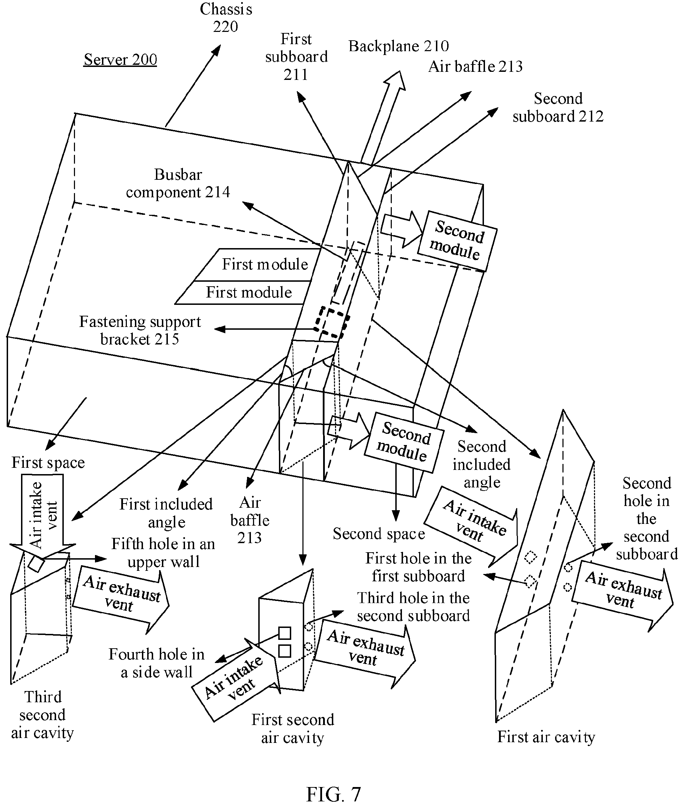

It should be understood that FIG. 2 shows an example in which the backplane in the chassis includes one air baffle 213. However, this embodiment of this application is not limited thereto. For example, the backplane may include two air baffles (as shown in FIG. 6), or the backplane may include three air baffles (as shown in FIG. 7), or the backplane includes more air baffles.

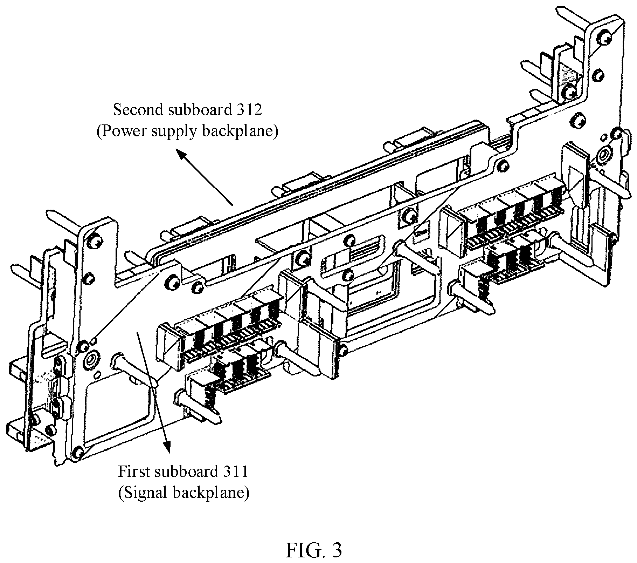

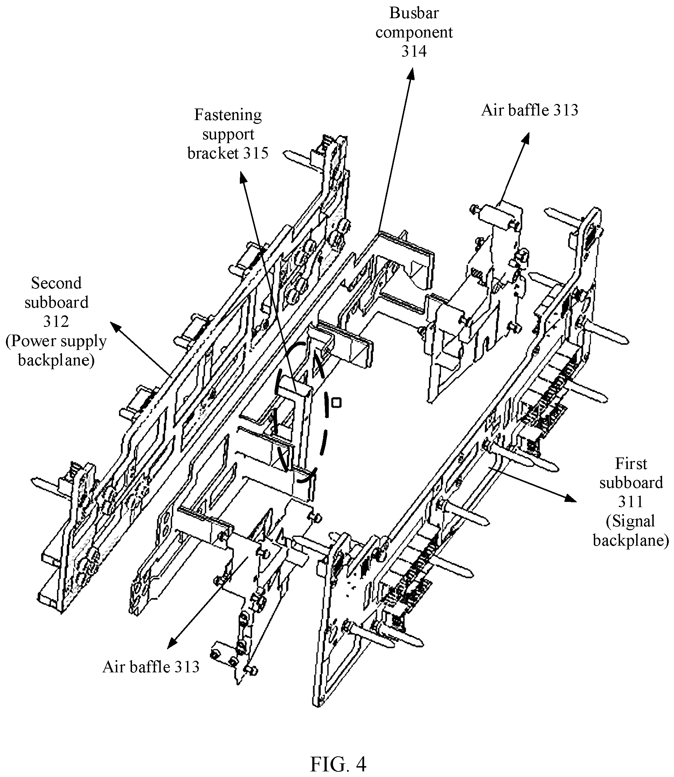

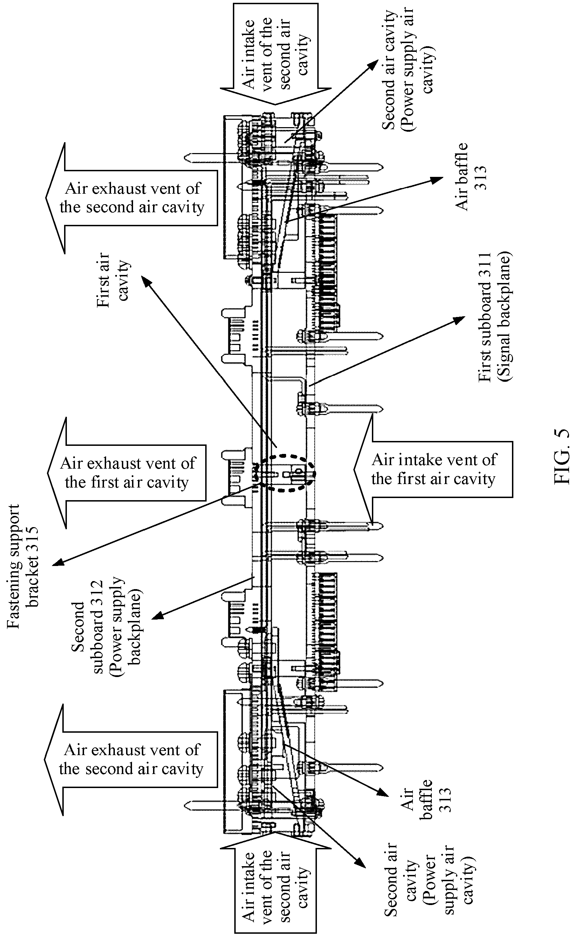

For example, the following describes, with reference to FIG. 3 to FIG. 5, a specific structure of a backplane including two air baffles. FIG. 3 is a schematic diagram of a backplane structure according to this application, FIG. 4 is an exploded diagram of the backplane structure according to this application, and FIG. 5 is a top view of the backplane structure according to this application.

The backplane 300 shown in FIG. 3 to FIG. 5 includes a first subboard 311, a second subboard 312, and two air baffles 313. The first subboard 311 in FIG. 3 to FIG. 5 may correspond to the first subboard 211 in FIG. 2, FIG. 6, and FIG. 7. The second subboard 312 in FIG. 3 to FIG. 5 may correspond to the second subboard 212 in FIG. 2, FIG. 6, and FIG. 7. The air baffle 313 in FIG. 3 to FIG. 5 may correspond to the air baffle 213 in FIG. 2, FIG. 6, and FIG. 7. As shown in FIG. 3 and FIG. 5, there is an included angle between the air baffle 313 and the first subboard 312 and an included angle between the air baffle 313 and the second subboard 313. Therefore, the air baffle 313 may be referred to as an inclined part.

As shown in FIG. 3 and FIG. 5, the first subboard 311 is isolated from the second subboard 312. In other words, a specific distance is set between the first subboard and the second subboard. For example, the spacing may be 25 mm, 30 mm, 35 mm, or the like. This embodiment of this application is not limited thereto.

As shown in FIG. 3 and FIG. 5, the first subboard 311 is connected to the second subboard 312 by using a busbar (Busbar) component 314. The busbar component 314 is configured to supply power to the first subboard 311. A signal may be transferred between the first subboard 311 and the second subboard 312 by using the busbar component 214.

Optionally, a fastening support bracket 315 is disposed between the first subboard 311 and the second subboard 312, and the fastening support bracket 315 is configured to fasten the first subboard 311 and the second subboard 312. For example, as shown in FIG. 4, the fastening support bracket 315 is a structure in an inverted-F shape, and the fastening support bracket may alternatively be in another shape. This embodiment of this application is not limited thereto.

The two air baffles 313 are located between the first subboard 311 and the second subboard 312, and are separately disposed at a position close to a side wall of a chassis of a server.

In the following, a structure of the first air cavity and that of the second air cavity in the chassis are further described with reference to FIG. 2.

The first air cavity is enclosed by a first part of the first subboard 211, a first part of the second subboard 212, a first part of the upper wall of the chassis, a first part of the lower wall, and the air baffle 213. It should be understood that, in FIG. 2, when only one air baffle is disposed in the chassis of the server, the area enclosing the first air cavity further needs to include a first part of the side wall of the chassis. In the following, as shown in FIG. 3, the area enclosing the first air cavity may not include the side wall of the chassis.

A first hole is disposed in the first part of the first subboard 211, and a second hole is disposed in the first part of the second subboard 212. In the first air cavity, airflow enters the first air cavity from the first hole, and flows out of the first air cavity through the second hole.

It should be understood that, as shown in FIG. 2, when the air baffle intersects with the side wall of the chassis of the server, the first part of the first subboard may be all of the first subboard. When the air baffle does not intersect with the side wall of the chassis of the server, the first part of the first subboard may include an area that is on the first subboard and that encloses the first air cavity.

The second air cavity may be enclosed by an area in any one of the following manners:
Manner 1: When the air baffle 213 intersects with the side wall of the chassis of the server, the second air cavity is enclosed by a second part of the second subboard 212, a second part of the side wall of the chassis of the server, a second part of the upper wall, a second part of the lower wall, and the air baffle 213. A cross section of the second air cavity is in a triangle shape. FIG. 2 shows a schematic structural diagram of the second air cavity in the manner 1.

It should be understood that the second part of the second subboard is an area that is on the second subboard and that encloses the second air cavity. Similarly, the second part of the side wall of the server is an area that is on the side wall and that encloses the second air cavity, the second part of the upper wall is an area that is on the upper wall and that encloses the second air cavity, and the second part of the lower wall is an area that is on the lower wall and that encloses the second air cavity.

Manner 2: When the air baffle 213 does not intersect with the side wall of the chassis of the server, the second air cavity is enclosed by a second part of the first subboard 211, the second part of the second subboard 212, the second part of the side wall of the chassis of the server, the second part of the upper wall, the second part of the lower wall, and the air baffle 213. A cross section of the second air cavity is in a right-angled trapezoid shape.

It should be noted that, in FIG. 2, a side wall that is of the chassis and that encloses the first air cavity and a side wall that is of the chassis and that encloses the second air cavity are on different sides.

A hole may be disposed in the area enclosing the second air cavity in any one of the following manners:
Manner 1: A third hole is disposed in the second part of the second subboard (namely, the area that is on the second subboard and that encloses the second air cavity), and a fourth hole is disposed in the second part of the side wall of the chassis. In this case, in the second air cavity, airflow enters the second air cavity from the fourth hole, and flows out of the second air cavity through the third hole.
Manner 2: The third hole is disposed in the second part of the second subboard, the fourth hole is disposed in the second part of the side wall of the chassis, and a fifth hole is disposed in the second part of the upper wall of the chassis. In this case, in the second air cavity, the airflow enters the second air cavity from the fourth hole and /or the fifth hole, and flows out of the second air cavity through the third hole.

Optionally, a hole opening rate of the first subboard 211 is greater than a first hole opening rate threshold, and a hole opening rate of the second subboard 212 is greater than a second hole opening rate threshold. The hole opening rate of the first subboard is used to indicate a ratio of a sum of areas of all holes on the first subboard to an area of the first subboard, and the hole opening rate of the second subboard is used to indicate a ratio of a sum of areas of all holes on the second subboard to an area of the second subboard.

Optionally, when the areas of all the holes are the same, the hole opening rate of the first subboard may also indicate a quantity of holes per unit area of the first subboard. Similarly, the hole opening rate of the second subboard may also indicate a quantity of holes per unit area of the second subboard.

It should be understood that the first hole opening rate threshold or the second hole opening rate threshold may be a maximum hole opening rate of an existing single-layer backplane or a closely-bonded two layers of backplanes. For example, based on a service requirement, the first hole opening rate threshold and the second hole opening rate threshold are 20%.

In a single-layer backplane structure of a conventional server, a signal and a power supply need to be routed on the backplane at the same time. Therefore, there is limitation on opening a hole, and a hole opening rate is relatively small, for example, is only 10%. However, in this embodiment of this application, in a two-layer structure design, the signal and the power supply are separately routed on different subboards, and less routing is required on a single subboard. Therefore, in this embodiment of this application, there is less limitation on opening a hole, and the hole opening rate is increased. Because the hole opening rate of the subboard in this embodiment of this application is relatively large, resistance of the air cavity to the airflow can be reduced. This ensures smooth airflow in the chassis and improves heat dissipation performance of the server.

It should be understood that, during actual application, a specific value of the first hole opening rate threshold and that of the second hole opening rate threshold may be determined based on an actual situation. This embodiment of this application is not limited thereto.

As shown in FIG. 2, the first subboard 211, the second subboard 212, and the upper wall and the lower wall of the chassis 220 divide space inside the chassis into two parts: first space and second space. Similar to a manner in which the first module and the second module are connected to the chassis in FIG. 1, in the first space, the first module is connected to the first subboard by using an interface of the first subboard, and is specifically connected to the first subboard by using the interface that is of the first subboard and that is in the air intake vent area of the first air cavity. In the second space, the second module is connected to the second subboard by using an interface of the second subboard, and is specifically connected to the second subboard by using the interface that is of the second subboard and that is in the air exhaust vent area of the second air cavity. The air intake vent area of the first air cavity is an area in which the airflow enters into the first air cavity. The air exhaust vent area of the second air cavity is an area in which the airflow flows out of the second air cavity.

For example, as shown in FIG. 2, an air intake vent of the first air cavity is the first hole in the first subboard, and the air intake vent area of the first air cavity may be represented as a circular area, in the first space, which uses the first hole as a center and uses a preset length as a radius. Alternatively, the air intake vent area of the first air cavity may be represented as a square area or a rectangular area that uses the first hole as the center and uses the preset length as a side length. An air exhaust vent of the second air cavity is the third hole in the second subboard, and the air exhaust vent area of the second air cavity may be represented as a circular area, in the second space, which uses the third hole as a center and uses a preset length as a radius. Alternatively, the air exhaust vent area of the second air cavity may be represented as a square area or a rectangular area that uses the third hole as the center and uses the preset length as a side length. When there are a plurality of first holes in the first space, the air intake vent area of the first air cavity may be a circular area or an area in another shape (for example, a square or a rectangle) that is determined according to a preset algorithm and that uses an area enclosed by the plurality of first holes as a center, to ensure that the airflow to the first air cavity may pass through the first module in the area. Similarly, when there are a plurality of second holes in the second space, the air exhaust vent area of the second air cavity may be a circular area or an area in another shape (for example, a square or a rectangle) that is determined according to a preset algorithm and that uses an area enclosed by the plurality of third holes as a center, to ensure that the airflow in the second air cavity may pass through the second module in the area.

When the at least one first module is connected to the chassis by using the first subboard, the first air cavity is used for the at least one first module to dissipate heat. Specifically, the airflow enters the chassis from a side that is of the chassis and that is close to the first subboard, passes through the at least one first module, enters the first air cavity through the first hole in the first subboard, and then flows out of the first air cavity through the second hole in the second subboard. In this way, heat of the at least one first module is taken out of the chassis.

It should be understood that a system heat dissipation fan (not shown in the figure) is disposed in a tail part (a right side of the second subboard) of the chassis. The system heat dissipation fan mainly controls a direction of the airflow that passes through the at least one first module, so that the airflow may pass through the first module in the described direction and take the heat out of the chassis.

For the second module, because each second module is provided with an independent fan, the fan may be configured to control a direction of the airflow that passes through the second module. Specifically, when the hole in the second air cavity is disposed in the manner 1, the airflow enters the second air cavity from the fourth hole in the side wall of the chassis, then flows out of the second air cavity through the third hole in the second subboard, and flows out of the chassis after passing through the at least one second module, to take heat of the at least one second module out of the chassis. When the hole in the second air cavity is disposed in the manner 2, the airflow enters the second air cavity from the fifth hole in the upper wall of the chassis and/or the fourth hole in the side wall, then flows out of the second air cavity through the third hole in the second subboard, and flows out of the chassis after passing through the at least one second module, to take the heat of the at least one second module out of the chassis.

Compared with a heat dissipation structure of a chassis of the conventional server, in this embodiment of this application, the backplane is disposed as a structure of two isolated subboards, so that a cavity is formed between the two subboards. At least one air baffle is disposed between the two subboards, to divide the cavity into the first air cavity that is used for the first module to dissipate heat and the second air cavity that is specially used for the second module to dissipate heat. In other words, in this embodiment of this application, the first module and the second module each have an independent heat dissipation air cavity. Therefore, in this application, independent heat dissipation of the first module and the second module is implemented. This improves heat dissipation efficiency of the first module and that of the second module, and further improves heat dissipation performance of the entire server.

The following further describes, with reference to FIG. 6, the chassis of the server provided in this embodiment of this application. A difference between FIG. 6 and FIG. 2 lies in that in FIG. 6, space enclosed by the first subboard, the second subboard, the upper wall of the chassis, and the lower wall of the chassis is divided into one first air cavity and two second air cavities by using two air baffles.

Specifically, as shown in FIG. 6, the chassis 220 of the server 200 includes the backplane 210, and the backplane 210 further includes the first subboard 211, the second subboard 212, and two air baffles 213. The first subboard 211 is isolated from the second subboard 212, the first subboard 211 is parallel to the second subboard 212, and both the first subboard 211 and the second subboard 212 are perpendicular to the side wall of the chassis of the server. As shown in FIG. 6, the two air baffles 213 are located between the first subboard 211 and the second subboard 212, and each of the two air baffles 213 forms an included angle with the first subboard 211 and forms an included angle with the second subboard 212. The two air baffles 213 may be disposed symmetrically by using a central axis of the chassis of the server as a reference, or may be disposed asymmetrically.

Space enclosed by the first subboard 211, the second subboard 212, and the side wall, the upper wall, and the lower wall of the chassis 220 is divided into one first air cavity and two second air cavities by using the two air baffles 213. A hole used for air circulation is disposed in an area enclosing the first air cavity, and the first air cavity is used for at least one first module to dissipate heat. Each first module is connected to the first subboard by using an interface that is of the first subboard and that is in the air intake vent area of the first air cavity. A hole used for air circulation is disposed in an area enclosing each of the second air cavity, and the second air cavity is used for at least one second module to dissipate heat. Each second module is connected to the second subboard by using an interface that is of the second subboard and that is in an air exhaust vent area of the second air cavity. Two included angles are respectively formed between the air baffle 213 and the first subboard and between the air baffle 213 and the second subboard. A first included angle is formed between the air baffle 213 and the first subboard 212, and a second included angle is formed between the air baffle 213 and the second subboard 212.

The chassis in FIG. 6 includes the two second air cavities. Therefore, two groups of second modules may be disposed in the chassis of the server, and each group of second modules may include at least one second module. Each second air cavity may correspond to one group of second modules, and each second air cavity is used for a corresponding group of second modules to dissipate heat. The chassis in FIG. 2 includes one second air cavity. Therefore, only one group of second modules may be disposed in the chassis of the server, and the one second air cavity may be used for the one group of second modules to dissipate heat.

As shown in FIG. 6, the difference between FIG. 6 and FIG. 2 further lies in that a part enclosing the first air cavity in FIG. 6 may not include the side wall of the chassis, and a part enclosing the first air cavity in FIG. 2 needs to include the side wall of the chassis. Specifically, the first air cavity in FIG. 6 is enclosed by the two air baffles 213, a first part of the first subboard 211, a first part of the second subboard 212, a first part of the upper wall of the chassis, and a first part of the lower wall of the chassis. The first air cavity in FIG. 2 is enclosed by the air baffle 213, the first part of the first subboard 212, the first part of the second subboard 212, and the first part of the side wall of the chassis.

It should be understood that structures of the two second air cavities in FIG. 6 are similar to the structure of the second air cavity in FIG. 2, and the two second air cavities may be disposed symmetrically by using the central axis of the chassis of the server as a reference. With reference to FIG. 3, the following describes an airflow direction by using the structure of one second air cavity. Because the structures of the two second air cavities are symmetrical, for the structure and an airflow direction of the other second air cavity, refer to the description of the one second air cavity. To avoid repetition, details are not described herein again.

As shown in FIG. 6, the first subboard 211, the second subboard 212, and the upper wall and the lower wall of the chassis 220 divide space inside the chassis into two parts: first space and second space. Similar to the manner in which the first module and the second module are connected to the chassis in FIG. 1, in the first space, the first module is connected to the first subboard by using an interface of the first subboard, and is specifically connected to the first subboard by using the interface that is of the first subboard and that is in the air intake vent area of the first air cavity. In the second space, the second module is connected to the second subboard by using an interface of the second subboard, and is specifically connected to the second subboard by using the interface that is of the second subboard and that is in the air exhaust vent area of the second air cavity. The second modules in FIG. 3 may be classified into two groups. One group of second modules is disposed in the air exhaust vent area of the one second air cavity, and the other group of second modules is disposed in the air exhaust vent area of the other second air cavity. The air intake vent area of the first air cavity is an area in which airflow enters into the first air cavity. The air exhaust vent area of the second air cavity is an area in which the airflow flows out of the second air cavity.

When the at least one first module is connected to the chassis by using the first subboard, the first air cavity is used for the at least one first module to dissipate heat. Specifically, the airflow enters the chassis from a side that is of the chassis and that is close to the first subboard, passes through the at least one first module, enters the first air cavity through a first hole in the first subboard, and then flows out of the first air cavity through a second hole in the second subboard. In this way, heat of the at least one first module is taken out of the chassis.

It should be understood that a system heat dissipation fan (not shown in the figure) is disposed in a tail part (a right side of the second subboard) of the chassis. The system heat dissipation fan mainly controls a direction of the airflow that passes through the at least one first module, so that the airflow may pass through the first module in the described direction and take the heat out of the chassis.

For the second module, because the second module is provided with an independent fan, the fan may be configured to control a direction of airflow that passes through the second module. Specifically, when the hole in the second air cavity is disposed in the manner 1, the airflow enters the second air cavity from a fourth hole in the side wall of the chassis, then flows out of the second air cavity through a third hole in the second subboard, and flows out of the chassis after passing through the at least one second module, to take heat of the at least one second module out of the chassis. When the hole in the second air cavity is disposed in the manner 2, the airflow enters the second air cavity from a fifth hole in the upper wall of the chassis and/or the fourth hole in the side wall, then flows out of the second air cavity through the third hole in the second subboard, and flows out of the chassis after passing through the at least one second module, to take the heat of the at least one second module out of the chassis.

Compared with a heat dissipation structure of the conventional server, in this embodiment of this application, the backplane is disposed as a structure of two isolated subboards, so that a cavity is formed between the two subboards. At least one air baffle is disposed between the two subboards, to divide the cavity into the first air cavity that is used for the first module to dissipate heat and the second air cavity that is specially used for the second module to dissipate heat. In other words, in this embodiment of this application, the first module and the second module each have an independent heat dissipation air cavity. Therefore, in this application, independent heat dissipation of the first module and the second module is implemented. This improves heat dissipation efficiency of the first module and that of the second module, and further improves heat dissipation performance of the entire server.

The foregoing describes, with reference to FIG. 2, an example in which the chassis has one air baffle, and describes, with reference to FIG. 6, an example in which the chassis has two air baffles. However, this is not limited in this embodiment of this application. Similar to the example in FIG. 2 or FIG. 6, the chassis of the server in this embodiment of this application may include more air baffles.

For example, the chassis of the server has three or more air baffles. As shown in FIG. 7, when there are three air baffles 213 in the chassis of the server, the three air baffles 213 may be located between the first subboard 211 and the second subboard 212. Each of the three air baffles forms an included angle with the first subboard and forms an included angle with the second subboard. Space enclosed by the first subboard 211, the second subboard 212, and the side wall, the upper wall, and the lower wall of the chassis is divided into four air cavities by using the three air baffles, and the four air cavities may include one first air cavity and three second air cavities. In a possible implementation, as shown in FIG. 7, structures of two of the three second air cavities, namely, a 1^{st} second air cavity and a 2^{nd} second air cavity, may be similar to the structures of the two second air cavities in FIG. 6. A 3^{rd} second air cavity may be enclosed by two of the three air baffles, and the upper wall and the lower wall of the chassis. An air intake vent of the 3^{rd} second air cavity is a hole in the upper wall of the chassis, and an air exhaust vent is a hole in the second subboard. Similarly, one group of second modules corresponding to the 3^{rd} second air cavity may be connected to the second subboard by using an interface that is of the second subboard and that is in an air exhaust vent area of the second air cavity. Specifically, for an airflow direction in the second air cavity, refer to the foregoing descriptions in FIG. 2 and FIG. 6. To avoid repetition, details are not described herein again.

When more air baffles (for example, four, five, and the like) are disposed in the chassis of the server, a structure of a second air cavity is similar to structures of the second air cavities enclosed by the three air baffles. To avoid repetition, details are not described herein again.

It should be understood that, the examples of values in the foregoing embodiment are intended to help a person skilled in the art better understand the embodiments of the present application, but are not intended to limit the scope of the present application.

It should be noted that content in the embodiments of the present application may be combined with each other, and this embodiment of this application is not limited thereto.

It should be noted that the chassis in FIG. 2 to FIG. 7 are merely intended to help a person skilled in the art understand the embodiments of the present application, instead of limiting the embodiments of the present application to illustrated specific values or specific scenarios in the examples. A person skilled in the art certainly can make various equivalent modifications or changes according to the examples given in FIG. 2 and FIG. 7, and such modifications or changes also fall within the protection scope of the embodiments of the present application.

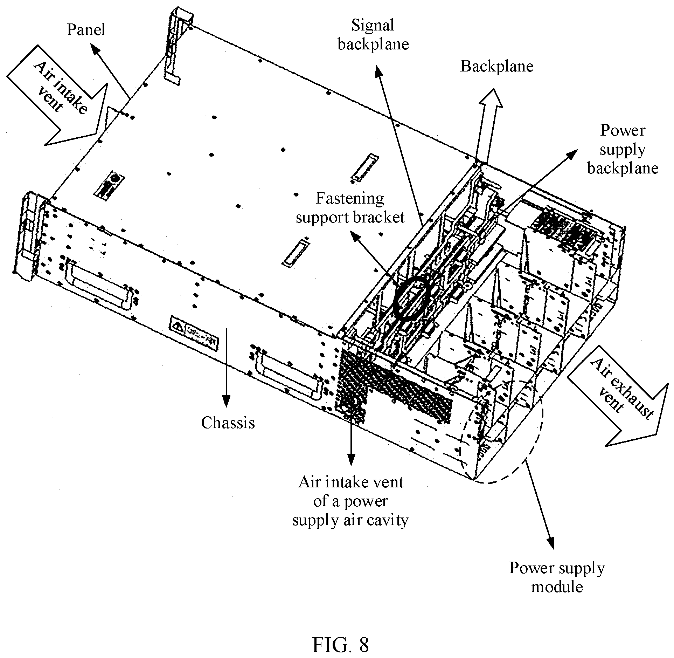

The foregoing describes a structure of the chassis of the server in the embodiments of this application with reference to FIG. 2 to FIG. 7. With reference to FIG. 8, the following further describes a heat dissipation structure provided in an embodiment of this application by using an example in which a server is a blade server.

As shown in FIG. 8, the blade server includes a chassis, at least one first module, and at least one second module. The chassis includes a backplane. The backplane is disposed in the chassis, and the backplane includes a first subboard, a second subboard, and at least one air baffle. A power supply module corresponds to the second module of the server shown in FIG. 2, FIG. 6, and FIG. 7, a power supply backplane corresponds to the second subboard shown in FIG. 2, FIG. 6, and FIG. 7, a computation module corresponds to the first module of the server shown in FIG. 2, FIG. 6, and FIG. 7, and a signal backplane corresponds to the first subboard shown in FIG. 2, FIG. 6, and FIG. 7. In this layout, when a fan of the power supply module works, cooling airflow enters the power supply air cavity through a hole in a side wall of the chassis, and flows out of the power supply air cavity through a hole in the power supply backplane. Then, the cooling airflow passes through the power supply module and flows out through a power fan, to take heat of the power supply module away. When a system fan of the server works, the cooling airflow may enter the chassis through an inlet (for example, an air intake vent disposed on a panel) at a front end of the chassis, and when passing through the computation module, the cooling airflow takes heat of the computation module away. Then the airflow carrying the heat of the computation module enters a system air cavity through an air intake vent of the system air cavity, and flows out of the system air cavity through an air exhaust vent of the system air cavity, to take the heat of the computation module out of the chassis.

It should be understood that the power supply backplane may be configured to be connected to the power supply module, and convert a voltage to supply power to modules in the chassis. The signal backplane may be used for communication between the modules in the chassis.

In this embodiment of this application, because the power supply module has the fan, and the power supply module is provided with an independent air cavity, namely, the power supply air cavity, the fan of the power supply module may control the airflow to enter into and flow out of the power supply air cavity, to dissipate heat for the power supply module. Specifically, in this embodiment of this application, the power supply module may be connected to the power supply backplane, and the computation module may be connected to the signal backplane. The power supply module may be disposed at an air exhaust vent of the power supply air cavity, and the computation module may be disposed at a position in front of the air intake vent of the system air cavity in the chassis. The power supply module corresponds to the second module of the server shown in FIG. 2, FIG. 6, and FIG. 7, the power supply backplane corresponds to the second subboard shown in FIG. 2, FIG. 6, and FIG. 7, the computation module corresponds to the first module of the server shown in FIG. 2, FIG. 6, and FIG. 7, and the signal backplane corresponds to the first subboard shown in FIG. 2, FIG. 6, and FIG. 7. In this layout, when the fan of the power supply module works, the cooling airflow enters the power supply air cavity through the hole in the side wall of the chassis, and flows out of the power supply air cavity through the hole in the power supply backplane. Then, the cooling airflow passes through the power supply module and flows out through the power fan, to take the heat of the power supply module away. When the system fan of the server works, the cooling airflow may enter the chassis through the inlet (for example, the air intake vent disposed on the panel) at the front end of the chassis, and when passing through the computation module, the cooling airflow takes the heat of the computation module away. Then the airflow carrying the heat of the computation module enters the system air cavity through the air intake vent of the system air cavity, and flows out of the system air cavity through the air exhaust vent of the system air cavity, to take the heat of the computation module out of the chassis.

Specifically, for a specific structure of the chassis, a heat dissipation process in the chassis, and beneficial effects that can be implemented, refer to the foregoing descriptions in FIG. 2 to FIG. 8. To avoid repetition, details are not described herein again.

In this embodiment of this application, the power supply air cavity is specially used for the power supply module to dissipate heat, and the system air cavity is specially used for the computation module to dissipate heat. This avoids a problem that the power supply module and the computation module are coupled together to dissipate heat by using a same air cavity. Therefore, in this embodiment of this application, a heat dissipation structure of the power supply module can be decoupled from that of the computation module, to implement independent heat dissipation of the power supply module and the computation module. This avoids heat accumulation between the power supply module and the computation module, and improves heat dissipation performance of the server.

In a possible embodiment, this embodiment of this application may be further applied to a rack server. The rack server includes at least one first module and at least one second module. The chassis includes a backplane. The backplane is disposed in the chassis, and the backplane includes a first subboard, a second subboard, and at least one air baffle. A specific heat dissipation structure and a heat dissipation process are similar to those in FIG. 8. To avoid repetition, details are not described herein again.

Further embodiments of the present invention are provided in the following. It should be noted that the numbering used in the following section does not necessarily need to comply with the numbering used in the previous sections.

Embodiment 1. A chassis of a server, comprising a backplane, wherein the backplane is disposed in the chassis of the server, and the backplane comprises:
a first subboard, a second subboard, and at least one air baffle, wherein
the first subboard is isolated from the second subboard, the first subboard is parallel to the second subboard, and both the first subboard and the second subboard are perpendicular to a side wall of the chassis of the server;
the at least one air baffle is located between the first subboard and the second subboard, and each of the at least one air baffle forms an included angle with the first subboard and forms an included angle with the second subboard; and
space enclosed by the first subboard, the second subboard, and the side wall, an upper wall, and a lower wall of the chassis is divided into a first air cavity and at least one second air cavity by using the at least one air baffle, a hole used for air circulation is disposed in an area enclosing the first air cavity, the first air cavity is used for at least one first module to dissipate heat, each of the at least one first module is connected to the first subboard by using an interface that is of the first subboard and that is in an air intake vent area of the first air cavity, a hole used for air circulation is disposed in an area enclosing each second air cavity, the second air cavity is used for at least one second module to dissipate heat, and each of the at least one second module is connected to the second subboard by using an interface that is of the second subboard and that is in an air exhaust vent area of the second air cavity.

Embodiment 2. The chassis of the server according to embodiment 1, wherein
when a first air baffle intersects with the side wall of the chassis of the server, the second air cavity is enclosed by a second part of the second subboard, a second part of the side wall of the chassis of the server, a second part of the upper wall, a second part of the lower wall, and the first air baffle.

Embodiment 3. The chassis of the server according to embodiment 1, wherein
when a first air baffle does not intersect with the side wall of the chassis of the server, the second air cavity is enclosed by a second part of the first subboard, a second part of the second subboard, a second part of the side wall of the chassis of the server, a second part of the upper wall, a second part of the lower wall, and the first air baffle.

Embodiment 4. The chassis of the server according to embodiment 2 or 3, wherein that the hole used for air circulation is disposed in the area enclosing the second air cavity comprises:
a third hole is disposed in the second part of the second subboard, a fourth hole is disposed in the second part of the side wall of the chassis, and in the second air cavity, airflow enters the second air cavity from the fourth hole in the side wall of the chassis, and flows out of the second air cavity through the third hole in the second subboard.

Embodiment 5. The chassis of the server according to embodiment 2 or 3, wherein that the hole used for air circulation is disposed in the area enclosing the second air cavity comprises:
a third hole is disposed in the second part of the second subboard, a fourth hole is disposed in the second part of the side wall of the chassis, a fifth hole is disposed in the second part of the upper wall of the chassis, and in the second air cavity, airflow enters the second air cavity from the fourth hole and/or the fifth hole, and flows out of the second air cavity through the third hole in the second subboard.

Embodiment 6. The chassis of the server according to embodiment 2, wherein
the first air cavity is enclosed by the first subboard, a first part of the second subboard, a first part of the upper wall of the chassis, a first part of the lower wall, a first part of the side wall, and the air baffle, or the first air cavity is enclosed by the first subboard, a first part of the second subboard, a first part of the upper wall of the chassis, a first part of the lower wall, and the air baffle; and
that the hole used for air circulation is disposed in the area enclosing the first air cavity comprises:
   a first hole is disposed on the first subboard, a second hole is disposed in the first part of the second subboard, and in the first air cavity, airflow enters the first air cavity from the first hole in the first subboard, and flows out of the first air cavity through the second hole in the second subboard.

Embodiment 7. The chassis of the server according to embodiment 3, wherein
the first air cavity is enclosed by a first part of the first subboard, a first part of the second subboard, a first part of the upper wall of the chassis, a first part of the lower wall, and the air baffle, or the first air cavity is enclosed by a first part of the first subboard, a first part of the second subboard, a first part of the upper wall of the chassis, a first part of the lower wall, and the air baffle; and
that the hole used for air circulation is disposed in the area enclosing the first air cavity comprises:
   a first hole is disposed in the first part of the first subboard, a second hole is disposed in the first part of the second subboard, and in the first air cavity, airflow enters the first air cavity from the first hole in the first subboard, and flows out of the first air cavity through the second hole in the second subboard.

Embodiment 8. The chassis of the server according to any one of embodiments 1 to 7, wherein
a value of a spacing between the first subboard and the second subboard is related to a size of the chassis of the server and/or a module layout inside the chassis.

Embodiment 9. The chassis of the server according to any one of embodiments 1 to 8, wherein
the first subboard is connected to the second subboard by using a busbar component, and the busbar component is configured to supply power to the second subboard.

Embodiment 10. The chassis of the server according to any one of embodiments 1 to 9, wherein
a fastening support bracket is disposed between the first subboard and the second subboard, and the fastening support bracket is configured to fasten the first subboard and the second subboard, to form the spacing between the first subboard and the second subboard.

Embodiment 11. The chassis of the server according to any one of embodiments 1 to 10, wherein
a hole opening rate of the first subboard is greater than a first hole opening rate threshold, a hole opening rate of the second subboard is greater than a second hole opening rate threshold, the hole opening rate of the first subboard is used to indicate a ratio of a sum of areas of all holes on the first subboard to an area of the first subboard, and the hole opening rate of the second subboard is used to indicate a ratio of a sum of areas of all holes on the second subboard to an area of the second subboard.

Embodiment 12. The chassis of the server according to any one of embodiments 1 to 11, wherein each of the at least one first module comprises a graphics processing unit GPU module or a central processing unit CPU module; and
each of the at least one second module is provided with an independent fan.

Embodiment 13. The chassis of the server according to any one of embodiments 1 to 12, wherein
the first subboard is a signal backplane, and the second subboard is a power supply backplane.

Embodiment 14. The chassis of the server according to any one of embodiments 1 to 13, wherein
the server is a rack server or a blade server.

Embodiment 15. A server, wherein the server comprises a chassis, at least one first module, and at least one second module, the chassis comprises a backplane, the backplane is disposed in the chassis, and the backplane comprises a first subboard, a second subboard, and at least one air baffle, wherein
the first subboard is isolated from the second subboard, the first subboard is parallel to the second subboard, and both the first subboard and the second subboard are perpendicular to a side wall of the chassis of the server;
the at least one air baffle is located between the first subboard and the second subboard, and each of the at least one air baffle forms an included angle with the first subboard and forms an included angle with the second subboard; and space enclosed by the first subboard, the second subboard, and the side wall, an upper wall, and a lower wall of the chassis is divided into a first air cavity and at least one second air cavity by using the at least one air baffle, a hole used for air circulation is disposed in an area enclosing the first air cavity, the first air cavity is used for the at least one first module to dissipate heat, each of the at least one first module is connected to the first subboard by using an interface that is of the first subboard and that is in an air intake vent area of the first air cavity, a hole used for air circulation is disposed in an area enclosing each second air cavity, the second air cavity is used for the at least one second module to dissipate heat, and each of the at least one second module is connected to the second subboard by using an interface that is of the second subboard and that is in an air exhaust vent area of the second air cavity.

Embodiment 16. The server according to embodiment 15, wherein:
when a first air baffle intersects with the side wall of the chassis of the server, the second air cavity is enclosed by a second part of the second subboard, a second part of the side wall of the chassis of the server, a second part of the upper wall, a second part of the lower wall, and the first air baffle.

Embodiment 17. The server according to embodiment 15, wherein:
when a first air baffle does not intersect with the side wall of the chassis of the server, the second air cavity is enclosed by a second part of the first subboard, a second part of the second subboard, a second part of the side wall of the chassis of the server, a second part of the upper wall, a second part of the lower wall, and the first air baffle.

Embodiment 18. The server according to embodiment 15 or 16, wherein that the hole used for air circulation is disposed in the area enclosing the second air cavity comprises:
a third hole is disposed in the second part of the second subboard, a fourth hole is disposed in the second part of the side wall of the chassis, and in the second air cavity, airflow enters the second air cavity from the fourth hole in the side wall of the chassis, and flows out of the second air cavity through the third hole in the second subboard.

Embodiment 19. The server according to embodiment 15 or 16, wherein that the hole used for air circulation is disposed in the area enclosing the second air cavity comprises:
a third hole is disposed in the second part of the second subboard, a fourth hole is disposed in the second part of the side wall of the chassis, a fifth hole is disposed in the second part of the upper wall of the chassis, and in the second air cavity, airflow enters the second air cavity from the fourth hole and/or the fifth hole, and flows out of the second air cavity through the third hole in the second subboard.

Embodiment 20. The server according to embodiment 16, wherein:
the first air cavity is enclosed by the first subboard, a first part of the second subboard, a first part of the upper wall of the chassis, a first part of the lower wall, a first part of the side wall, and the air baffle, or the first air cavity is enclosed by the first subboard, a first part of the second subboard, a first part of the upper wall of the chassis, a first part of the lower wall, and the air baffle; and
that the hole used for air circulation is disposed in the area enclosing the first air cavity comprises:
   a first hole is disposed on the first subboard, a second hole is disposed in the first part of the second subboard, and in the first air cavity, airflow enters the first air cavity from the first hole in the first subboard, and flows out of the first air cavity through the second hole in the second subboard.

Embodiment 21. The server according to embodiment 17, wherein:
the first air cavity is enclosed by a first part of the first subboard, a first part of the second subboard, a first part of the upper wall of the chassis, a first part of the lower wall, and the air baffle, or the first air cavity is enclosed by a first part of the first subboard, a first part of the second subboard, a first part of the upper wall of the chassis, a first part of the lower wall, and the air baffle; and
that the hole used for air circulation is disposed in the area enclosing the first air cavity comprises:
   a first hole is disposed in the first part of the first subboard, a second hole is disposed in the first part of the second subboard, and in the first air cavity, airflow enters the first air cavity from the first hole in the first subboard, and flows out of the first air cavity through the second hole in the second subboard.

Embodiment 22. The server according to embodiments 15 to 21, wherein:
a value of a spacing between the first subboard and the second subboard is related to a size of the chassis of the server and/or a module layout inside the chassis.

Embodiment 23. The server according to any one of embodiments 15 to 22, wherein
a fastening support bracket is disposed between the first subboard and the second subboard, and the fastening support bracket is configured to fasten the first subboard and the second subboard, to form the spacing between the first subboard and the second subboard.

Embodiment 24. The server according to any one of embodiments 15 to 23, wherein
a hole opening rate of the first subboard is greater than a first hole opening rate threshold, a hole opening rate of the second subboard is greater than a second hole opening rate threshold, the hole opening rate of the first subboard is used to indicate a ratio of a sum of areas of all holes on the first subboard to an area of the first subboard, and the hole opening rate of the second subboard is used to indicate a ratio of a sum of areas of all holes on the second subboard to an area of the second subboard.

Embodiment 25. The server according to any one of embodiments 15 to 24, wherein
each of the at least one first module comprises a graphics processing unit GPU module or a central processing unit CPU module; and
each of the at least one second module is provided with an independent fan.

Embodiment 26. The server according to any one of embodiments 15 to 25, wherein
the first subboard is a signal backplane, and the second subboard is a power supply backplane.

Embodiment 27. The server according to any one of embodiments 15 to 26, wherein
the server is a rack server or a blade server.

"One embodiment" or "an embodiment" mentioned in the entire specification means that particular features, structures, or characteristics related to the embodiment are included in at least one embodiment of the present application. Therefore, "in one embodiment" or "in an embodiment" appearing throughout the entire specification does not necessarily refer to a same embodiment. In addition, these particular features, structures, or characteristics may be combined in one or more embodiments in any appropriate manner.

It should be further understood that, in the embodiments of the present application, "first", "second", "third", and "fourth" are only for distinguishing between pixels, and should not constitute any limitation on the protection scope of the present application.

The term "and/or" in this specification describes only an association relationship for describing associated objects and represents that there may be three relationships. For example, A and/or B may represent the following three cases: Only A exists, both A and B exist, and only B exists. In addition, the character "/" in this specification usually indicates an "or" relationship between the associated objects.

It should be understood that in the embodiments of the present application, "B corresponding to A" indicates that B is associated with A, and B may be determined based on A. However, it should further be understood that determining B based on A does not mean that B is determined based on A only. B may alternatively be determined based on A and/or other information.

A person of ordinary skill in the art may be aware that, units and algorithm steps of the examples described in combination with the embodiments disclosed in this specification may be implemented by electronic hardware or a combination of computer software and electronic hardware. Whether the functions are performed by hardware or software depends on particular applications and design constraint conditions of the technical solutions. A person skilled in the art may use different methods to implement the described functions for each particular application, but it should not be considered that the implementation goes beyond the scope of this application.

It may be clearly understood by a person skilled in the art that, for convenient and brief description, for a detailed working process of the foregoing system, apparatus, and unit, refer to a corresponding process in the foregoing method embodiments, and details are not described herein again.

In a plurality of embodiments provided in this application, it should be understood that the disclosed system, apparatus, and method may be implemented in another manner. For example, the described apparatus embodiments are merely examples. For example, division into the units is merely logical function division and may be other division in actual implementation. For example, a plurality of units or components may be combined or integrated into another system, or some features may be ignored or not performed. In addition, the displayed or discussed mutual coupling or a direct coupling or a communication connection may be implemented by using some interfaces. An indirect coupling or a communication connection between the apparatuses or units may be implemented in an electronic form, a mechanical form, or in another form.

The units described as separate parts may or may not be physically separate, and parts displayed as units may or may not be physical units, may be located in one position, or may be distributed on a plurality of network units. Some or all of the units may be selected based on an actual requirement to achieve the objectives of the solutions in the embodiments.

In addition, functional units in the embodiments of this application may be integrated into one processing unit, or each of the units may exist alone physically, or two or more units may be integrated into one unit.

The foregoing descriptions are merely specific implementations of this application, but are not intended to limit a protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A chassis (220) of a server (200), the chassis comprising a backplane (210), wherein the backplane is disposed in the chassis of the server, and the backplane comprises:
a first subboard (211), a second subboard (212), wherein
the first subboard is isolated from the second subboard, the first subboard is parallel to the second subboard; and
the chassis further comprising at least one air baffle (213) and wherein a first air baffle is located between the first subboard and the second subboard, and the first air baffle respectively forms an included angle with the first subboard and the second subboard, the first air baffle is one baffle of the at least one air baffle, a heat dissipation space in the chassis is divided into a first air cavity and at least one second air cavity, the first air cavity is used for at least one first module to dissipate heat, the at least one second air cavity is used for at least one second module to dissipate heat.

2. The chassis of a server according to claim 1, wherein the heat dissipation space is enclosed by the first subboard, the second subboard, and the side wall, an upper wall, and a lower wall of the chassis, and a lower wall of the chassis is divided into a first air cavity and at least one second air cavity by using the at least one air baffle, a hole used for air circulation is disposed in an area enclosing the first air cavity.

3. The chassis of a server according to claim 1 or 2, wherein
when the first air baffle intersects with the side wall of the chassis of the server, the second air cavity is enclosed by a second part of the second subboard, a second part of the side wall of the chassis of the server, a second part of the upper wall, a second part of the lower wall, and the first air baffle.

4. The chassis of the server according to claim 1 or 2, wherein
when the first air baffle does not intersect with the side wall of the chassis of the server, the second air cavity is enclosed by a second part of the first subboard, a second part of the second subboard, a second part of the side wall of the chassis of the server, a second part of the upper wall, a second part of the lower wall, and the first air baffle.

5. The chassis of the server according to claim 3 or 4, wherein that the hole used for air circulation is disposed in the area enclosing the second air cavity comprises:
a third hole is disposed in the second part of the second subboard, a fourth hole is disposed in the second part of the side wall of the chassis, and in the second air cavity, airflow enters the second air cavity from the fourth hole in the side wall of the chassis, and flows out of the second air cavity through the third hole in the second subboard.

6. The chassis of the server according to claim 3 or 4, wherein that the hole used for air circulation is disposed in the area enclosing the second air cavity comprises:
a third hole is disposed in the second part of the second subboard, a fourth hole is disposed in the second part of the side wall of the chassis, a fifth hole is disposed in the second part of the upper wall of the chassis, and in the second air cavity, airflow enters the second air cavity from the fourth hole and/or the fifth hole, and flows out of the second air cavity through the third hole in the second subboard.

7. The chassis of the server according to any one of claims 1 to 6, wherein
the first air cavity is enclosed by the first subboard, a first part of the second subboard, a first part of the upper wall of the chassis, a first part of the lower wall, a first part of the side wall, and the air baffle, or the first air cavity is enclosed by the first subboard, a first part of the second subboard, a first part of the upper wall of the chassis, a first part of the lower wall, and the air baffle; and
that the hole used for air circulation is disposed in the area enclosing the first air cavity comprises:
a first hole is disposed on the first subboard, a second hole is disposed in the first part of the second subboard, and in the first air cavity, airflow enters the first air cavity from the first hole in the first subboard, and flows out of the first air cavity through the second hole in the second subboard.

8. The chassis of the server according to any one of claims 1 to 7, wherein
the first air cavity is enclosed by a first part of the first subboard, a first part of the second subboard, a first part of the upper wall of the chassis, a first part of the lower wall, and the air baffle, or the first air cavity is enclosed by a first part of the first subboard, a first part of the second subboard, a first part of the upper wall of the chassis, a first part of the lower wall, and the air baffle; and
that the hole used for air circulation is disposed in the area enclosing the first air cavity comprises:
a first hole is disposed in the first part of the first subboard, a second hole is disposed in the first part of the second subboard, and in the first air cavity, airflow enters the first air cavity from the first hole in the first subboard, and flows out of the first air cavity through the second hole in the second subboard.

9. The chassis of the server according to any one of claims 1 to 8, wherein
a value of a spacing between the first subboard and the second subboard is related to a size of the chassis of the server and/or a module layout inside the chassis.

10. The chassis of the server according to any one of claims 1 to 9, wherein
the first subboard is connectable to the second subboard by using a busbar component (214), and the busbar component is configured to supply power to the second subboard.

11. The chassis of the server according to any one of claims 1 to 10, wherein
a fastening support bracket (215) is disposed between the first subboard and the second subboard, and the fastening support bracket is configured to fasten the first subboard and the second subboard, to form the spacing between the first subboard and the second subboard.

12. The chassis of the server according to any one of claims 1 to 11, wherein
a hole opening rate of the first subboard is greater than a first hole opening rate threshold, a hole opening rate of the second subboard is greater than a second hole opening rate threshold, the hole opening rate of the first subboard is used to indicate a ratio of a sum of areas of all holes on the first subboard to an area of the first subboard, and the hole opening rate of the second subboard is used to indicate a ratio of a sum of areas of all holes on the second subboard to an area of the second subboard.

13. The chassis of the server according to any one of claims 1 to 12, wherein
each of the at least one first module comprises a graphics processing unit GPU module or a central processing unit CPU module; and
each of the at least one second module is provided with an independent fan.

14. The chassis of the server according to any one of claims 1 to 13, wherein
the first subboard is a signal backplane, and the second subboard is a power supply backplane.

15. The chassis of the server according to any one of claims 1 to 13, wherein
the server is a rack server or a blade server.

## Patentansprüche

1. Chassis (220) eines Servers (200), wobei das Chassis eine Rückwandplatine (210) umfasst, wobei die Rückwandplatine in dem Chassis des Servers angeordnet ist und die Rückwandplatine Folgendes umfasst:
eine erste Unterplatine (211), eine zweite Unterplatine (212), wobei
die erste Unterplatine von der zweiten Unterplatine isoliert ist, die erste Unterplatine parallel zu der zweiten Unterplatine verläuft; und
wobei das Chassis ferner mindestens ein Luftleitblech (213) umfasst, und wobei ein erstes Luftleitblech zwischen der ersten Unterplatine und der zweiten Unterplatine angeordnet ist, und das erste Luftleitblech jeweils einen eingeschlossenen Winkel mit der ersten Unterplatine und der zweiten Unterplatine ausbildet, das erste Luftleitblech ein Leitblech des mindestens einen Luftleitblechs ist, ein Wärmeableitungsraum in dem Chassis in einen ersten Lufthohlraum und mindestens einen zweiten Lufthohlraum unterteilt ist, der erste Lufthohlraum für mindestens ein erstes Modul zum Ableiten von Wärme verwendet wird, der mindestens eine zweite Lufthohlraum für mindestens ein zweites Modul zum Ableiten von Wärme verwendet wird.

2. Chassis eines Servers nach Anspruch 1, wobei der Wärmeableitungsraum durch die erste Unterplatine, die zweite Unterplatine und die Seitenwand, eine obere Wand und eine untere Wand des Chassis eingehaust ist, und eine untere Wand des Chassis in einen ersten Lufthohlraum und mindestens einen zweiten Lufthohlraum unter Verwendung des mindestens einen Luftleitblechs unterteilt ist, ein zur Luftzirkulation verwendetes Loch in einem Bereich angeordnet ist, der den ersten Lufthohlraum einhaust.

3. Chassis eines Servers nach Anspruch 1 oder 2, wobei,
wenn sich die erste Luftleitplatte mit der Seitenwand des Chassis des Servers überschneidet, der zweite Lufthohlraum durch einen zweiten Teil der zweiten Unterplatine, einen zweiten Teil der Seitenwand des Chassis des Servers, einen zweiten Teil der oberen Wand, einen zweiten Teil der unteren Wand und die erste Luftleitplatte eingehaust ist.

4. Chassis des Servers nach Anspruch 1 oder 2, wobei,
wenn sich die erste Luftleitplatte nicht mit der Seitenwand des Chassis des Servers überschneidet, der zweite Lufthohlraum durch einen zweiten Teil der ersten Unterplatine, einen zweiten Teil der zweiten Unterplatine, einen zweiten Teil der Seitenwand des Chassis des Servers, einen zweiten Teil der oberen Wand, einen zweiten Teil der unteren Wand und die erste Luftleitplatte eingehaust ist.

5. Chassis des Servers nach Anspruch 3 oder 4, wobei der Umstand, dass das zur Luftzirkulation verwendete Loch in dem Bereich angeordnet ist, der den zweiten Lufthohlraum einhaust, Folgendes umfasst:
ein drittes Loch ist in dem zweiten Teil der zweiten Unterplatine angeordnet, ein viertes Loch ist in dem zweiten Teil der Seitenwand des Chassis und in dem zweiten Lufthohlraum angeordnet, ein Luftstrom tritt aus dem vierten Loch in der Seitenwand des Chassis in den zweiten Lufthohlraum ein und strömt durch das dritte Loch in der zweiten Unterplatine aus dem zweiten Lufthohlraum heraus.

6. Chassis des Servers nach Anspruch 3 oder 4, wobei der Umstand, dass das zur Luftzirkulation verwendete Loch in dem Bereich angeordnet ist, der den zweiten Lufthohlraum einhaust, Folgendes umfasst:
ein drittes Loch ist in dem zweiten Teil der zweiten Unterplatine angeordnet, ein viertes Loch ist in dem zweiten Teil der Seitenwand des Chassis angeordnet, ein fünftes Loch ist in dem zweiten Teil der oberen Wand des Chassis und in dem zweiten Lufthohlraum angeordnet, ein Luftstrom tritt aus dem vierten Loch und/oder dem fünften Loch in den zweiten Lufthohlraum ein und strömt durch das dritte Loch in der zweiten Unterplatine aus dem zweiten Lufthohlraum heraus.

7. Chassis des Servers nach einem der Ansprüche 1 bis 6, wobei der erste Lufthohlraum durch die erste Unterplatine, einen ersten Teil der zweiten Unterplatine, einen ersten Teil der oberen Wand des Chassis, einen ersten Teil der unteren Wand, einen ersten Teil der Seitenwand und das Luftleitblech eingehaust ist, oder der erste Lufthohlraum durch die erste Unterplatine, einen ersten Teil der zweiten Unterplatine, einen ersten Teil der oberen Wand des Chassis, einen ersten Teil der unteren Wand und das Luftleitblech eingehaust ist; und
der Umstand, dass das zur Luftzirkulation verwendete Loch in dem Bereich angeordnet ist, der den ersten Lufthohlraum einhaust, Folgendes umfasst:
ein erstes Loch ist auf der ersten Unterplatine angeordnet, ein zweites Loch ist in dem ersten Teil der zweiten Unterplatine angeordnet, und ein Luftstrom in dem ersten Lufthohlraum tritt aus dem ersten Loch in der ersten Unterplatine in den ersten Lufthohlraum ein und strömt durch das zweite Loch in der zweiten Unterplatine aus dem ersten Lufthohlraum heraus.

8. Chassis des Servers nach einem der Ansprüche 1 bis 7, wobei der erste Lufthohlraum durch einen ersten Teil der ersten Unterplatine, einen ersten Teil der zweiten Unterplatine, einen ersten Teil der oberen Wand des Chassis, einen ersten Teil der unteren Wand und das Luftleitblech eingehaust ist, oder der erste Lufthohlraum durch einen ersten Teil der ersten Unterplatine, einen ersten Teil der zweiten Unterplatine, einen ersten Teil der oberen Wand des Chassis, einen ersten Teil der unteren Wand und das Luftleitblech eingehaust ist; und
der Umstand, dass das zur Luftzirkulation verwendete Loch in dem Bereich angeordnet ist, der den ersten Lufthohlraum einhaust, Folgendes umfasst:
ein erstes Loch ist in dem ersten Teil der ersten Unterplatine angeordnet, ein zweites Loch ist in dem ersten Teil der zweiten Unterplatine angeordnet, und ein Luftstrom in dem ersten Lufthohlraum tritt aus dem ersten Loch in der ersten Unterplatine in den ersten Lufthohlraum ein und strömt durch das zweite Loch in der zweiten Unterplatine aus dem ersten Lufthohlraum heraus.

9. Chassis des Servers nach einem der Ansprüche 1 bis 8, wobei ein Wert einer Beabstandung zwischen der ersten Unterplatine und der zweiten Unterplatine mit einer Größe des Chassis des Servers und/oder einem Modullayout innerhalb des Chassis zusammenhängt.

10. Chassis des Servers nach einem der Ansprüche 1 bis 9, wobei die erste Unterplatine mit der zweiten Unterplatine unter Verwendung einer Sammelschienenkomponente (214) verbindbar ist, und die Sammelschienenkomponente dazu konfiguriert ist, die zweite Unterplatine mit Leistung zu versorgen.

11. Chassis des Servers nach einem der Ansprüche 1 bis 10, wobei eine Befestigungsstützhalterung (215) zwischen der ersten Unterplatine und der zweiten Unterplatine angeordnet ist, und die Befestigungsstützhalterung dazu konfiguriert ist, die erste Unterplatine und die zweite Unterplatine zu befestigen, um die Beabstandung zwischen der ersten Unterplatine und der zweiten Unterplatine auszubilden.

12. Chassis des Servers nach einem der Ansprüche 1 bis 11, wobei eine Lochöffnungsrate der ersten Unterplatine größer als ein erster Schwellenwert der Lochöffnungsrate ist, eine Lochöffnungsrate der zweiten Unterplatine größer als ein zweiter Schwellenwert der Lochöffnungsrate ist, die Lochöffnungsrate der ersten Unterplatine verwendet wird, um ein Verhältnis einer Summe von Bereichen aller Löcher auf der ersten Unterplatine zu einem Bereich der ersten Unterplatine anzugeben, und die Lochöffnungsrate der zweiten Unterplatine verwendet wird, um ein Verhältnis einer Summe von Bereichen aller Löcher auf der zweiten Unterplatine zu einem Bereich der zweiten Unterplatine anzugeben.

13. Chassis des Servers nach einem der Ansprüche 1 bis 12, wobei jedes des mindestens einen ersten Moduls ein Modul der Grafikverarbeitungseinheit, GPU-Modul, oder ein Modul der Zentralverarbeitungseinheit, CPU-Modul, umfasst; und
jedes des mindestens einen zweiten Moduls mit einem unabhängigen Lüfter versehen ist.

14. Chassis des Servers nach einem der Ansprüche 1 bis 13, wobei die erste Unterplatine eine Signalrückwandplatine ist, und die zweite Unterplatine eine Rückwandplatine zur Leistungsversorgung ist.

15. Chassis des Servers nach einem der Ansprüche 1 bis 13, wobei der Server ein Rack-Server oder ein Blade-Server ist.

## Revendications

1. Châssis (220) d'un serveur (200), le châssis comprenant un fond de panier (210), dans lequel le fond de panier est disposé dans le châssis du serveur, et le fond de panier comprend :
un premier sous-tableau (211), un second sous-tableau (212), dans lequel
le premier sous-tableau est isolé du second sous-tableau, le premier sous-tableau est parallèle au second sous-tableau ; et
le châssis comprend en outre au moins un déflecteur d'air (213), et dans lequel un premier déflecteur d'air est situé entre le premier sous-tableau et le second sous-tableau, et le premier déflecteur d'air forme respectivement un angle inclus avec le premier sous-tableau et le second sous-tableau, le premier déflecteur d'air est un déflecteur de l'au moins un déflecteur d'air, un espace de dissipation de chaleur dans le châssis est divisé en une première cavité d'air et au moins une seconde cavité d'air, la première cavité d'air est utilisée pour au moins un premier module pour dissiper la chaleur, l'au moins une seconde cavité d'air est utilisée pour au moins un second module pour dissiper la chaleur.

2. Châssis d'un serveur selon la revendication 1, dans lequel l'espace de dissipation de chaleur est entouré par le premier sous-tableau, le second sous-tableau, et la paroi latérale, une paroi supérieure et une paroi inférieure du châssis, et une paroi inférieure du châssis est divisée en une première cavité d'air et au moins une seconde cavité d'air à l'aide de l'au moins un déflecteur d'air, un trou utilisé pour la circulation de l'air est disposé dans une zone entourant la première cavité d'air.

3. Châssis d'un serveur selon la revendication 1 ou 2, dans lequel lorsque le premier déflecteur d'air rencontre la paroi latérale du châssis du serveur, la seconde cavité d'air est entourée par une seconde partie du second sous-tableau, une seconde partie de la paroi latérale du châssis du serveur, une seconde partie de la paroi supérieure, une seconde partie de la paroi inférieure, et le premier déflecteur d'air.

4. Châssis du serveur selon la revendication 1 ou 2, dans lequel lorsque le premier déflecteur d'air ne rencontre pas la paroi latérale du châssis du serveur, la seconde cavité d'air est entourée par une seconde partie du premier sous-tableau, une seconde partie du second sous-tableau, une seconde partie de la paroi latérale du châssis du serveur, une seconde partie de la paroi supérieure, une seconde partie de la paroi inférieure, et le premier déflecteur d'air.

5. Châssis du serveur selon la revendication 3 ou 4, dans lequel le fait que le trou utilisé pour la circulation de l'air est disposé dans la zone entourant la seconde cavité d'air comprend :
un troisième trou est disposé dans la seconde partie du second sous-tableau, un quatrième trou est disposé dans la seconde partie de la paroi latérale du châssis, et dans la seconde cavité d'air, le flux d'air entre dans la seconde cavité d'air par le quatrième trou dans la paroi latérale du châssis, et sort de la seconde cavité d'air par le troisième trou dans le second sous-tableau.

6. Châssis du serveur selon la revendication 3 ou 4, dans lequel le fait que le trou utilisé pour la circulation de l'air est disposé dans la zone entourant la seconde cavité d'air comprend :
un troisième trou est disposé dans la seconde partie du second sous-tableau, un quatrième trou est disposé dans la seconde partie de la paroi latérale du châssis, un cinquième trou est disposé dans la seconde partie de la paroi supérieure du châssis, et dans la seconde cavité d'air, le flux d'air entre dans la seconde cavité d'air par le quatrième trou et/ou le cinquième trou, et sort de la seconde cavité d'air par le troisième trou dans le second sous-tableau.

7. Châssis du serveur selon l'une quelconque des revendications 1 à 6, dans lequel
la première cavité d'air est entourée par le premier sous-tableau, une première partie du second sous-tableau, une première partie de la paroi supérieure du châssis, une première partie de la paroi inférieure, une première partie de la paroi latérale, et le déflecteur d'air, ou la première cavité d'air est entourée par le premier sous-tableau, une première partie du second sous-tableau, une première partie de la paroi supérieure du châssis, une première partie de la paroi inférieure, et le déflecteur d'air ; et
le fait que le trou utilisé pour la circulation de l'air est disposé dans la zone entourant la première cavité d'air comprend :
un premier trou est disposé sur le premier sous-tableau, un deuxième trou est disposé dans la première partie du second sous-tableau, et dans la première cavité d'air, le flux d'air entre dans la première cavité d'air par le premier trou dans le premier sous-tableau, et sort de la première cavité d'air par le deuxième trou dans le second sous-tableau.

8. Châssis du serveur selon l'une quelconque des revendications 1 à 7, dans lequel
la première cavité d'air est entourée par une première partie du premier sous-tableau, une première partie du second sous-tableau, une première partie de la paroi supérieure du châssis, une première partie de la paroi inférieure, et le déflecteur d'air, ou la première cavité d'air est entourée par une première partie du premier sous-tableau, une première partie du second sous-tableau, une première partie de la paroi supérieure du châssis, une première partie de la paroi inférieure, et le déflecteur d'air ; et
le fait que le trou utilisé pour la circulation de l'air est disposé dans la zone entourant la première cavité d'air comprend :
un premier trou est disposé dans la première partie du premier sous-tableau, un deuxième trou est disposé dans la première partie du second sous-tableau, et dans la première cavité d'air, le flux d'air entre dans la première cavité d'air par le premier trou dans le premier sous-tableau, et sort de la première cavité d'air par le deuxième trou dans le second sous-tableau.

9. Châssis du serveur selon l'une quelconque des revendications 1 à 8, dans lequel
une valeur d'un espacement entre le premier sous-tableau et le second sous-tableau est liée à une taille du châssis du serveur et/ou une disposition de module à l'intérieur du châssis.

10. Châssis du serveur selon l'une quelconque des revendications 1 à 9, dans lequel
le premier sous-tableau peut être connecté au second sous-tableau à l'aide d'un composant de barre omnibus (214), et le composant de barre omnibus est configuré pour alimenter le second sous-tableau.

11. Châssis du serveur selon l'une quelconque des revendications 1 à 10, dans lequel
une console de support de fixation (215) est disposée entre le premier sous-tableau et le second sous-tableau, et la console de support de fixation est configurée pour fixer le premier sous-tableau et le second sous-tableau, pour former l'espacement entre le premier sous-tableau et le second sous-tableau.

12. Châssis du serveur selon l'une quelconque des revendications 1 à 11, dans lequel
un taux d'ouverture de trous du premier sous-tableau est supérieur à un premier seuil de taux d'ouverture de trous, un taux d'ouverture de trous du second sous-tableau est supérieur à un second seuil de taux d'ouverture de trous, le taux d'ouverture de trous du premier sous-tableau est utilisé pour indiquer un rapport d'une somme de surfaces de tous les trous sur le premier sous-tableau à une surface du premier sous-tableau, et le taux d'ouverture de trous du second sous-tableau est utilisé pour indiquer un rapport d'une somme de surfaces de tous les trous sur le second sous-tableau à une surface du second sous-tableau.

13. Châssis du serveur selon l'une quelconque des revendications 1 à 12, dans lequel
chacun de l'au moins un premier module comprend un module d'unité de traitement graphique GPU ou un module d'unité centrale de traitement CPU ; et
chacun de l'au moins un second module est pourvu d'un ventilateur indépendant.

14. Châssis du serveur selon l'une quelconque des revendications 1 à 13, dans lequel
le premier sous-tableau est un fond de panier dédié aux signaux, et le second sous-tableau est un fond de panier dédié à l'alimentation.

15. Châssis du serveur selon l'une quelconque des revendications 1 à 13, dans lequel le serveur est un serveur en baie ou un serveur lame.
